# EUROPEAN PATENT APPLICATION

(11) **EP 4 746 614 A1**
(43) Date of publication of application: **20.05.2026**
(21) Application number: 25212586.9
(22) Date of filing: 31.10.2025
(51) Int. Cl.: H10B 12/00, G11C 8/14, G11C 5/06

(54) **CONTACT PAD STRUCTURES FOR WORDLINES IN THREE-DIMENSIONAL MEMORY CIRCUITS**

(30) Priority: 13.11.2024 US 202463720167 P; 05.06.2025 US 202519230073
(71) Applicant: Samsung Electronics Co., Ltd., Suwon-si, Gyeonggi-do 16677 (KR)
(72) Inventor: KIM, Dongwan, San Jose, CA, 95134 (US); LEE, Don Koun, San Jose, CA, 95134 (US); AGRAWAL, Nidhi, San Jose, CA, 95134 (US); JEONG, Young Doo, San Jose, CA, 95134 (US); NOSHIN, Maliha, San Jose, CA, 95134 (US); KANAGO, Anthony, San Jose, CA, 95134 (US); AKHTAR, Mohd Kamran, San Jose, CA, 95134 (US); KIM, Dohyung, San Jose, CA, 95134 (US); LEE, Siwoo, San Jose, CA, 95134 (US)
(74) Representative: Kuhnen & Wacker Patent- und Rechtsanwaltsbüro PartG mbB

(57) **Abstract**

A system and a method for a contact pad structure are disclosed. The contact pad structure includes at least a first pad and a second pad. The first pad is on a first contact point and connected to a first wordline, WL, that is positioned lengthwise in a first direction and at a first distance from the first contact point. The second pad is on a second contact point and connected to a second WL that is positioned lengthwise in the first direction and at a second distance from the second contact point. The first and second pads are aligned in a second direction based on the first and second contact points. The first and second WLs correspond to row lines of a memory circuit.

## Description

### TECHNICAL FIELD

The disclosure generally relates to memory devices. More particularly, the subject matter disclosed herein relates to contact pad structure for wordlines in memory circuits.

### BACKGROUND

The present background section is intended to provide context only, and the disclosure of any concept in this section does not constitute an admission that said concept is prior art.

Three-dimensional (3-D) memory configurations have been increasingly popular. 3-D memory devices, such as vertically stacked dynamic random-access memory (VSDRAM) and vertical NAND (V-NAND) flash memory, include memory cells that are stacked vertically to increase storage density. One feature of 3-D memory circuits is the arrangement of control lines in a staircase structure. The staircase is employed to form the electrical connection between the control gate and contact. However, when the number of layers increases, the usable area for the memory channel decreases. In addition, structural support for a large number of layers may present problems. Accordingly, staircase-free designs aim at removing the staircase configuration while maintaining the same level of desired density. One particular feature of staircase-free memory circuits is contact structures for wordlines.

Existing techniques for designing contact pads for wordlines have several problems. One problem is large parasitic capacitances in the pad area. Another problem is the difficulty in alignment of the contact pads.

The above information disclosed in this Background section is only for enhancement of understanding of the background of the disclosure and therefore it may contain information that does not constitute prior art.

### SUMMARY

To overcome these issues, systems and methods are described herein for a technique of providing a contact pad structure for WLs in a three-dimensional (3-D) memory device. In some embodiments, the contact pad structure includes at least a first pad and a second pad. The first pad is on a first contact point and connected to a first WL that is positioned lengthwise in a first direction and at a first distance from the first contact point. The second pad is on a second contact point and connected to a second WL that is positioned lengthwise in the first direction and at a second distance from the second contact point. The first and second pads are aligned in a second direction based on the first and second contact points. The first and second WLs correspond to row lines of a memory circuit.

In some embodiments, the first and second pads and the first and second WLs are of conductive material. In some embodiments, the first and second directions are substantially perpendicular. The first and second pads are separated by an insulating segment positioned lengthwise in the first direction and are localized within first and second sections of the first and second WLs, respectively.

### BRIEF DESCRIPTION OF THE DRAWINGS

In the following section, the aspects of the subject matter disclosed herein will be described with reference to exemplary embodiments illustrated in the figures, in which:
FIG. 1 is a block diagram illustrating a system that utilizes a 3-D memory circuit according to an embodiment.
FIG. 2 is a diagram illustrating a pad structure in a 3-D memory circuit according to an embodiment.
FIG. 3 is a diagram illustrating a comparison between a pad structure with localized connections and a pad structure with throughout connections according to an embodiment.
FIG. 4 is a diagram illustrating a first stage of the manufacturing process of the pad structure according to an embodiment.
FIG. 5 is a diagram illustrating a second stage of the manufacturing process of the pad structure according to an embodiment.
FIG. 6 is a diagram illustrating a third stage of the manufacturing process of the pad structure according to an embodiment.
FIG. 7 is a diagram illustrating a fourth stage of the manufacturing process of the pad structure according to an embodiment.
FIG. 8 is a diagram illustrating a fifth stage of the manufacturing process of the pad structure according to an embodiment.
FIG. 9 is a diagram illustrating a sixth stage of the manufacturing process of the pad structure according to an embodiment.
FIG. 10 is a diagram illustrating a seventh stage of the manufacturing process of the pad structure according to an embodiment.
FIG. 11 is a diagram illustrating an eighth stage of the manufacturing process of the pad structure according to an embodiment.
FIG. 12 is a diagram illustrating key features of the pad structure according to an embodiment.
FIG. 13 is a diagram illustrating a first optional configuration of the pad structure according to an embodiment.
FIG. 14 is a diagram illustrating a second optional configuration of the pad structure according to an embodiment.
FIG. 15 is a flow chart illustrating a process of manufacturing a pad structure for a memory circuit according to an embodiment.
FIG. 16 is a flow chart illustrating a process of etching a contact in a multi-tier configuration as part of a process of manufacturing a pad structure for a memory circuit according to an embodiment.
FIG. 17 is a flow chart illustrating a process of forming lateral recess isolation as part of a process of manufacturing a pad structure for a memory circuit according to an embodiment.
FIG. 18 is a flow chart illustrating a process of forming self-aligned plug as part of a process of manufacturing a pad structure for a memory circuit according to an embodiment.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Many applications, especially applications in Artificial Intelligence (AI) and signal processing, require a vast storage capacity and high throughput computations. To satisfy these needs, highly dense memory circuits in 3-D configurations are developed. In the following, systems and methods are described as a technique of providing a contact pad structure for WLs in a 3-D memory device. In some embodiments, the contact pad structure includes at least a first pad and a second pad. The first pad is on a first contact point and connected to a first WL that is positioned lengthwise in a first direction and at a first distance from the first contact point. The second pad is on a second contact point and connected to a second WL that is positioned lengthwise in the first direction and at a second distance from the second contact point. The first and second pads are aligned in a second direction based on the first and second contact points. The first and second WLs correspond to row lines of a memory circuit.

In some embodiments, the first and second pads and the first and second WLs are of conductive material. In some embodiments, the first and second directions are substantially perpendicular. The first and second pads are separated by an insulating segment positioned lengthwise in the first direction and are localized within first and second sections of the first and second WLs, respectively.

The contact pad structure described herein has several technical advantages. The pads are localized within small sections adjacent to the WLs instead of occupying the entire length of the WLs. Accordingly, the parasitic capacitances are much reduced, improving signal integrity in high-speed applications. By using conductive material (e.g., metal) only at places where contacts are needed, the manufacturing process is simplified and less costly. In addition, the pads are self-aligned by virtue of the contact points, eliminating the need for alignment procedures or tools. This is especially advantageous in fabrication processes.

In the following, figures depicting various components, structures, interconnections, configurations, and steps of fabrication, are mainly for illustrative purposes. They are not intended to describe these elements accurately. In some cases, relevant parts in a figure are shown clearly while other parts are shown with less sharpness or clarity to avoid confusion and improve clarity. These parts may be referenced in earlier figures and therefore do not need to be described again. These parts may also have little relationship with the part(s) being described. In addition, the shading of the parts in the figures may not have a consistent design and may be changed to maintain clarity and contrast in the figures. For example, part A may have a light shading in Fig. X but may be heavily shaded in Fig. Y . Moreover, as mentioned above, components in a figure may not be drawn with proper scales.

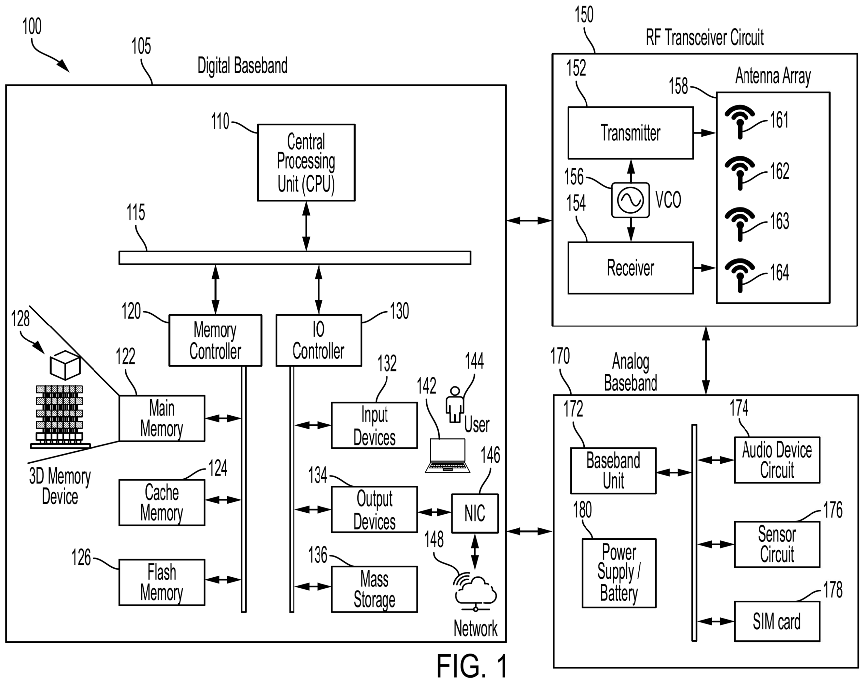

FIG. 1 is a block diagram illustrating a system that utilizes a 3-D memory circuit according to an embodiment. The system 100 includes a digital baseband circuit 105, a radio frequency (RF) transceiver circuit 150, and an analog baseband circuit 170. The system 100 may represent a digital system or a mobile system. When the system 100 is used as a digital system without mobile circuitry, the RF transceiver circuit 160, and the analog baseband circuit 190 are not used. In addition, when the system 100 is used as a mobile device, many of the digital devices are scaled back and some devices may not be available.

The digital baseband circuit 105 includes central processing unit (CPU) 110, a memory controller 120, and an I/O controller 130. The system 100 may include more or less than the above components. In addition, a component may be integrated into another component. The integration may be partial and/or overlapped. For example, the memory controller 120 and the I/O controller 130 may be integrated into one single controller.

The CPU 110 is a programmable device that may execute a program or a collection of instructions to carry out a task. It may be a host that controls or manages other processors or devices. In particular, the CPU 110 may include applications programming interfaces (APIs), applications, or drivers that are executed by the CPU 110 to perform specified tasks. The CPU 110 may be a general-purpose processor, a digital signal processor, a microcontroller, or a specially designed processor. It may include a single core or multiple cores. Each core may have multi-way multi-threading. The CPU 110 may have simultaneous multithreading feature to further exploit the parallelism due to multiple threads across the multiple cores. In addition, the CPU 110 may have internal caches at multiple levels. The CPU 110 communicates with other devices in the system via a bus 115. The bus 115 may be any suitable bus connecting the CPU 110 to other devices. For example, the bus 115 may be a Direct Media Interface (DMI). The bus 115 may also include other custom buses such as bus for the interface to the analog section when the system 100 is used as a mobile device.

The memory controller 120 controls memory devices such as a main memory 122, a cache memory 124, and a flash memory 126. The main memory 122 includes random access memory (RAM) including static RAM (SRAM) and dynamic RAM (DRAM) and/or the read-only memory (ROM) and other types of memory. The DRAM may include Synchronous DRAM (SDRAM), Double Data Rate SDRAM (DDR SDRAM) with variations (e.g., DDR2, DDR3, DDR4, DDR5, and DDR6). The main memory 122 may store instructions or programs, loaded from a mass storage device, that, when executed by the CPU 110, cause the CPU 110 to perform operations for a specified task. It may also store data used in the operations. The ROM may be a solid-state drive (SSD) and include instructions, programs, constants, or data that are maintained whether it is powered or not. In one embodiment, the main memory 122 includes a 3-D memory device or circuit 128 such as VSDRAM and V-NAND flash memory, or any other memory devices that have memory cells that are stacked vertically to increase storage density

The I/O controller 130 controls input devices 132, output devices 134, and mass storage 136. The input devices 132 may include a keyboard, a mouse, an image sensor or camera, a game console, and a microphone. Other input devices may also be available such as stylus, joystick, scanner, and light pen. The input devices may also have a user interface to interface to a computer or laptop 142 and/or a user 144. The output devices 134 may include a printer, a monitor or screen, a headset, and a multi-monitor set. When used as a computing device without mobile features, the monitor is a high-resolution display. For games and other multi-display mode, the multi-monitor set provides high-resolution with multiple monitors (e.g., three monitors). When used for mobile communication, the screen provides the primary interface for the user to navigate, access various applications and perform tasks. The screen may use organic light-emitting diode (OLED) (super retina) display with multi-touch or haptic touch feature. The mass storage 136 may include CD-ROM, hard disk, and solid-state drives (SSDs). The I/O controller 130 also has a network interface card (NIC) 146 which provides an interface to a network and wireless medium 148.

Additional devices or bus interfaces may be available for interconnections and/or expansion. Some examples may include the Peripheral Component Interconnect Express (PCIe) bus, the Universal Serial Bus (USB), etc.

The RF transceiver circuit 150 includes a transmitter 152, an antenna array 158, a voltage-controlled oscillator (VCO) 156, and a receiver 154. The RF circuit 150 operates at a high GHz frequency band to accommodate modern cellular equipment such as the wireless fifth generation (5G).

The transmitter 152 transmits the digital baseband data to the antenna array 158. The transmitter 152 may include a digital-to-analog converter (DAC), an automatic gain controller (AGC), an intermediate frequency (IF) circuit, a mixer, an RF circuit, and a power amplifier (PA). Other components may include filters, amplifiers, multiplexers, coaxial cables, phase shifters, etc. The DAC converts digital data f₁ into an analog signal f₂. The AGC automatically adjusts the signal amplitude of f₂ to generate a signal f₃ to maintain a consistent strength level in a dynamic and changing environment. The IF circuit performs intermediate frequency processes such as filtering to generate a signal f₄. The mixer converts the frequency of the signal f₄ to another frequency. This is done by mixing the signal f₄ with a signal vₜ from the VCO 156. Mixing here refers to frequency modulation which translates the signal f₄ to a signal f₅ at a different frequency. For transmitter, the translated frequency is higher than the frequency of f₄. The conversion is called up-conversion. For 5G communication, the frequency range may include low-band (below 1 GHz), mid-band (1 GHz to 6 GHz), and high-band (24 GHz to 53 GHz or higher). The resulting signal f₅ then goes through various radio frequency processes performed by the RF circuit such as high-pass filtering to produce a signal f₆. The signal f₆ is strengthened and amplified by the PA to produce a signal f₇. The signal f₇ then goes to the antenna array 158 to be transmitted to an appropriate destination and medium (e.g., base station). The antenna array 158 uses beam forming to focus radio waves from f₇ in a desired direction. The antenna array 158 may be used for both transmitting and receiving. On receiving, the antenna array 158 receives an RF signal and sends it to the receiver 154. The number of antennas in the antenna array 158 depends on the desired coverage. The antenna array 158 may include antennas 161, 162, 163, and 164 configured to operate with 5G communication, Gigabit Long Term Evolution (LTE), Wi-Fi (e.g., 2.4 GHz, 5 GHz, and 6Ghz), and Bluetooth, respectively. The number of antennas may be more or less than the above.

The VCO 156 couples multiple in-phase oscillators together to provide low phase noise oscillation. It generates signals vₜ and vᵣ to the mixers at specified frequencies. It may include multiple oscillation core circuits (or VCO cores) to provide high-frequency periodic signals.

The receiver 154 processes the received signal r₇ in a manner reverse from the transmitter 152. It may include a low noise amplifier (LNA), an RF circuit, a mixer, an IF circuit, an AGC, and an analog-to-digital converter (ADC). The receiver 154 may include more or less than the above components. The LNA amplifies the weak signal r₇ while maintaining a good signal-to-noise ratio (SNR) to produce a signal r₆ for further processing. The signal r₆ is next processed by the RF circuit such as band-pass filtering to provide a signal r₅. Additional filtering may be performed in the next stages. The signal r₅ is then mixed with the signal vᵣ from the VCO 156 to down convert the signal r₅ to a signal r₄ at an appropriate low frequency. Like the mixer in the transmitter 152 but with a reverse operation, the mixer in the receiver performs frequency modulation to translate the high frequency signal r₅ to a low frequency signal r₄. The signal r₄ goes through IF processing such as additional filtering by the IF circuit to produce a signal r₃. The AGC amplifies and strengthens the signal and generates a signal r₂. The ADC converts the analog signal r₂ into digital data r₁ which will be processed by the CPU 110.

The analog baseband circuit 170 provides analog processing for various components. It handles processing of signals and data between the digital baseband circuit and the RF transceiver circuit 150. It may include analog and digital components to perform various tasks including modulation/demodulation, controlling the RF transceiver circuit 150, special circuitry (e.g., 172) for 3G, 4G/LTE, Bluetooth, and 5G communication. It may also interface with an audio device circuit 174, a sensor circuit 176, a Subscriber Identity Module (SIM) card 178, and other components. The audio device circuit 174 may include operational blocks to process audio signals and perform audio-related functions such as filtering, correlation, speech recognition. It may include digital circuits to perform Fast Fourier Transform (FFT) to perform signal processing in the frequency domain. The sensor circuit 176 may include a variety of sensors such as proximity, ambient light, motion (accelerometer and gyroscope, compass, barometer, fingerprint sensor for touch identification (ID), image sensors for face ID, light detection and ranging (LiDAR) scanner, etc. The SIM card 178 is a small, removable chip that stores the user's phone number and carrier information, allowing the device to connect to a cellular network.

The power supply and battery circuit 180 provides power and battery backup supply to the entire system. It may include a charger to charge the battery. The battery may be a rechargeable battery, of Lithium-Ion battery. Power management may be performed by application software and circuits to provide low power mode and performance management.

The system 100 is an example that illustrates the role of 3-D memory devices in a laptop, desktop or mobile environment. In many cases, the environment of the applications adds additional requirements including low power consumption, reliable signal integrity, fault-tolerance, and reliable operations in extreme conditions including heat and tight space. Examples of other applications that would benefit from 3-D memory devices or circuits include mobile communication (e.g., smart phones, base stations, user equipment), cameras, vehicles, entertainment (e.g., games, multimedia, music, movies), technical designs (e.g., animation, graphics), medical (e.g., visualization, medical imaging), robotics, drones, automatic test equipment, audio processing, speech synthesizer, video and image analysis, vision, automatic face recognition, artificial intelligence (AI) applications, and data centers.

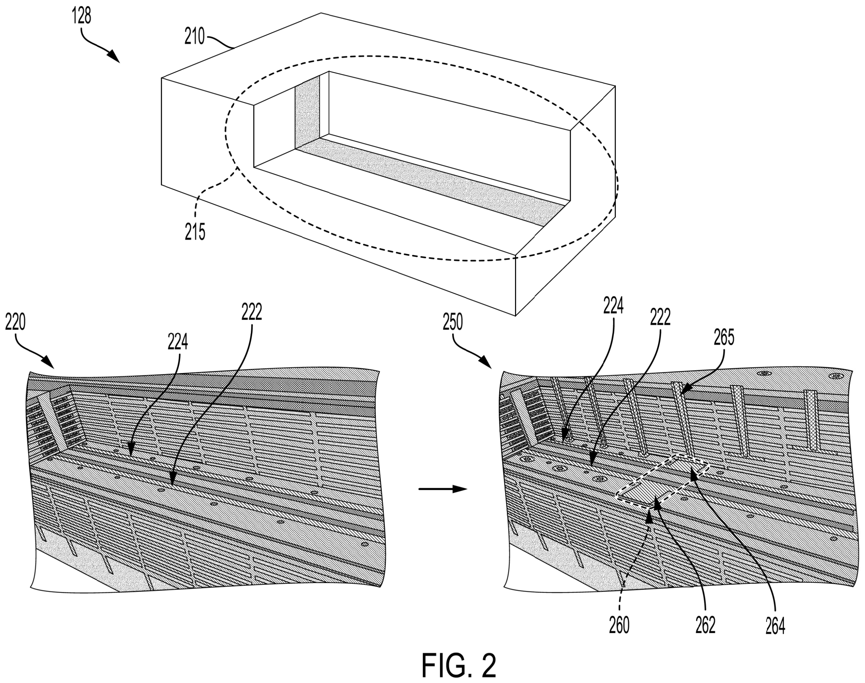

FIG. 2 is a diagram illustrating a pad structure in a 3-D memory circuit 128 according to an embodiment. The 3-D memory circuit 128 includes circuitry for stacked memory cells, wordlines (WLs), bit lines, select transistors, and interconnects for data transfer and control. These components are not shown the FIG. 2. Instead, FIG. 2 shows 3-D structures 210, 220, and 250.

The 3-D structure 210 depicts a typical 3-D circuit including several layers of semiconductor fabrication materials including dielectrics, oxides, silicon, and others. The structure 210 includes a cutout that shows the WL pad area 215 that corresponds to the structures 220 and 250. The structure 220 shows the WLs 222 and 224 that are extended along the length of the WL pad area 215. The WLs 222 and 224 are deposited with a conductive material including metal. The structure 250 shows a pad structure 260 and a contact pillar 265. Though only one component of each type is labeled, other similar components are labeled accordingly. The pad structure (or contact pad structure) 260 is a structure that connects the pillar 265 to the WLs 222 and 224. The pillar 265 and other pillars may be a hole, via, or a plug filled with a conductive material including metal such as Tungsten (W). It provides electrical connections to various interconnecting elements in the circuit such as WLs, bit lines, etc. As shown in FIG. 2, the contact pillar 265 is connected to the pad structure 260 which in turns is connected to the WLs 222 and 224.

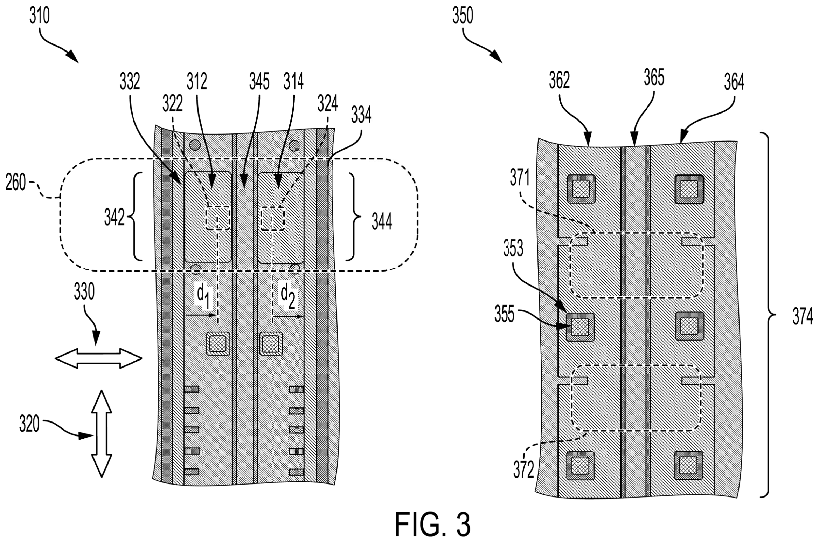

FIG. 3 is a diagram illustrating a comparison between the pad structure 260 with localized connections and a pad structure with entire connections according to an embodiment. The comparison is shown with a top view 310 and a top view 350. The top view 310 shows the view as seen from the top of the pad structure 260 and the top view 350 shows the view as seen from the top of a pad structure that includes the entire, or almost entire, WL in the WL pad area. The top view 350 may correspond to an existing technique.

The pad structure 260 includes two regions that are separated by a dielectric or insulating layer 345. The two regions include two pads: a first pad 312 and a second pad 314. The first pad 312 is disposed of, placed, arranged, positioned, located, or on a first contact point 322. The first contact point 322 is shown in dotted lines to indicate that it is underneath the first pad 312. It is the point that is used to make electrical contact with one or more points or parts in the circuit. The first pad 312 is placed directly on the first contact point 322 and is connected to the first contact point 322. In addition to being connected to the first contact point 312, the first pad 312 is connected to the WL 332. The WL 332 is extended from the WL of the memory cells in the memory circuit. It is positioned lengthwise or longitudinally in a first direction 320 and at a first distance di from the first contact point 322.

The second pad 314 is configured similarly in a symmetrical manner. The second pad 314 is disposed of, placed, arranged, positioned, located, or on a second contact point 324. The second contact point 324 is shown in dotted lines to indicate that it is underneath the second pad 314. It is the point that is used to make electrical contact with one or more points or parts in the circuit. The second pad 314 is placed directly on the second contact point 324 and is connected to the second contact point 324. In addition to being connected to the second contact point 314, the second pad 314 is connected to the WL 334. The WL 334 is extended from the WL of the memory cells in the memory circuit. It is positioned lengthwise or longitudinally in the first direction 320 and at a second distance d₂ from the second contact point 324. The WLs 332 and 334 correspond to row lines of the memory circuit 128. Assuming the geometries of the WLs 332 and 334 are similar, the distances d₁ and d₂ are also similar.

There are at least three aspects in the pad structure 260. In the first aspect, the width of the WL 332 or 334 is much smaller than the width of the first pad 312 or the second pad 314. Therefore, even if the WL 332 or 334 runs the entire length of the WL pad area, its total area is much less than if its width is the same as the width of the first pad 312 or the second pad 314. This aspect will become relevant when comparing with the pad structure shown in the top view 350. In the second aspect, the first and second pads 312 and 314 have a small area, occupying only localized sections 342 and 344 of the first and second WLs 332 and 334, respectively. Typically, this small area needs only to be sufficiently large to make a good connection with the corresponding contact point such as to cover the entire contact point. Accordingly, the total area of the metal for the entire pad structure including the WLs and the pads is much smaller than when the entire length of the WLs are used for connecting to the contact points. In the third aspect, the first and second pads are aligned in a second direction based on the first and second contact points. The alignment is self-aligned because the locations of the contact points provide the locations of the pads.

The top view 350 shows a first WL 362 and a second WL 364. The two WLs are separated by a dielectric or insulating layer 365 that runs alongside the WLs. These two WLs occupy the entire width from the outer layer to the insulating layer 365. They are placed directly above all the contact points and areas without contact points like area 371 and 372. A contact point typically includes a core area 355 and a dielectric circular segment 353 around the core area 355. The two WLs run the entire length, shown illustratively as segment 374. Compared to the pad structure in the top view 310, the pad structure of the top view 350 utilizes much more metal and therefore incur more parasitic capacitances. There are a lot of wasted metal areas such as the areas 371 and 372.

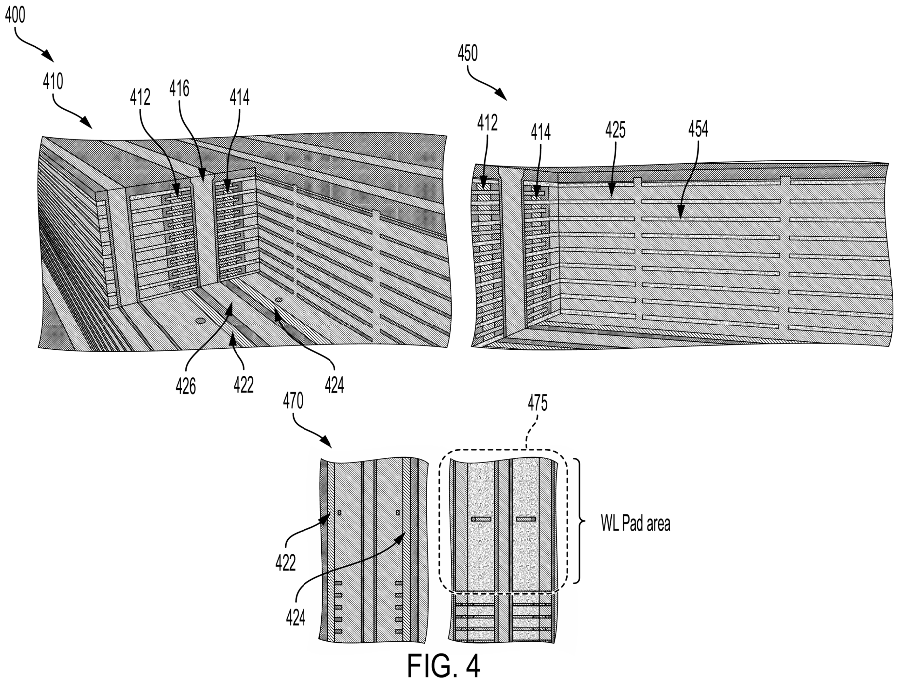

The pad structure 260 may be formed by a manufacturing process illustrated in FIGS 4 to 11. The diagrams shown in FIGS. 4 to 11 are mainly for illustrative purposes and are not intended to describe the exact components or configurations. As mentioned earlier, in some cases, relevant parts in a figure are shown clearly while other parts are shown with less sharpness or clarity to avoid confusion and improve clarity. Some components may be shown with white outlines or boundary lines to provide good visual display. These parts may be referenced in earlier figures and therefore do not need to be described again. These parts may also have little relationship with the part(s) being described. In addition, the shading of the parts in the figures may not have a consistent design and may be changed to maintain clarity and contrast in the figures. Each of the figures in FIGS. 4 to 11 shows three views: a 3-D view with a cutout in the upper left corner, a vertical view in the upper right corner, and a top view in the bottom.

FIG. 4 is a diagram illustrating a first stage 400 of the manufacturing process of the pad structure according to an embodiment. The first stage 400 includes a view 410, a view 450, and a view 470. The view 410 is a 3-D view with a cutout to show the overall structure. The view 450 shows the vertical plane. The view 470 shows the top view.

In the view 410, the first stage 400 extends WLs 412 and 414 to the WL pad area to become WL 422 and WL 424, respectively. The separating dielectric layer 416 becomes 426 in the WL pad area. In the view 450, the horizontal lines 414 and 424 represent the WLs. The view 450 also shows horizontal lines 425 and 454. In the view 470, the WLs 422 and 424 are shown running in parallel in the WL pad area 475.

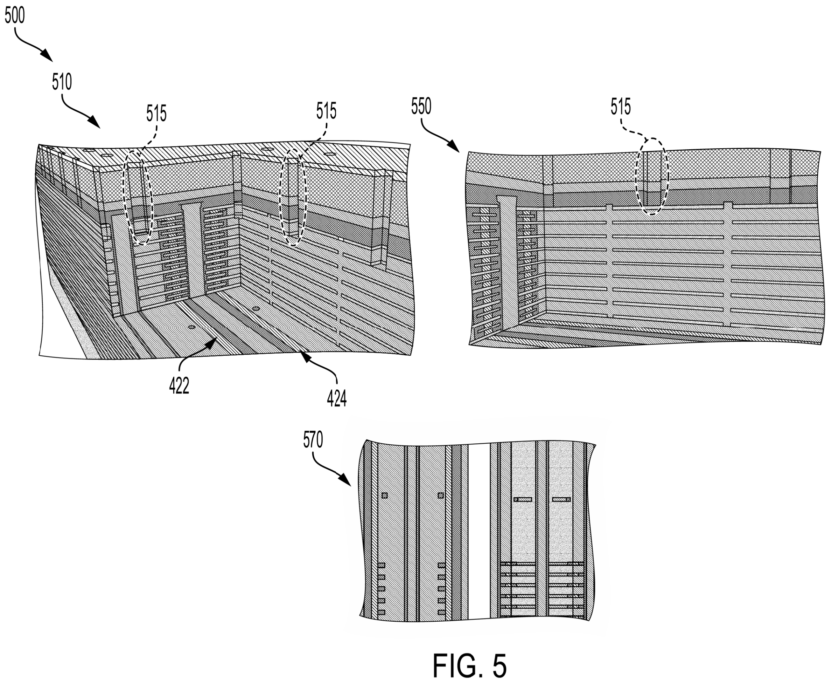

FIG. 5 is a diagram illustrating a second stage 500 of the manufacturing process of the pad structure according to an embodiment. The second stage 500 includes a 3-D view 510, a vertical view 550, and a top view 570. The second stage 500 performs a cell metal contact (CMC) process to create contact holes, vias, or plugs. The second stage 500 includes steps to form the contact holes: forming a hard mask, patterning using the hard mask to create a pattern, and etching using the pattern.

The 3-D view 510 shows the etching of the contact hole 515 and the WLs 422 and 424. The vertical view 550 shows the etching of the contact hole 515 as seen on the vertical surface. The numeral reference 515 refers to any of the contact holes being etched and not necessarily the same one. The top view 570 is the same as the top view 470 in FIG. 4 because the CMC etching does not create any new elements as seen from the top.

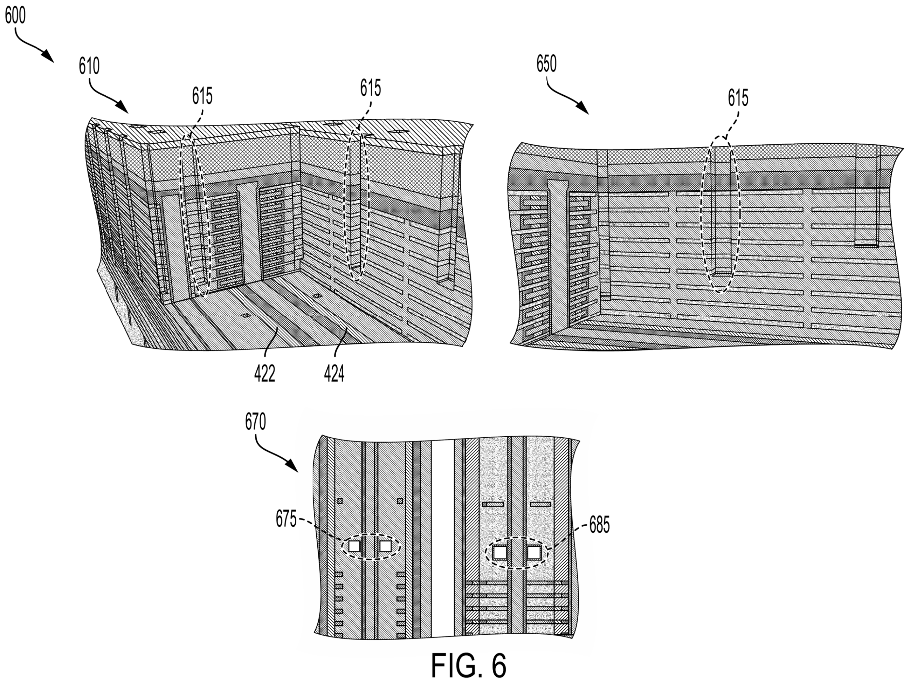

FIG. 6 is a diagram illustrating a third stage 600 of the manufacturing process of the pad structure according to an embodiment. The third stage 600 includes a 3-D view 610, a vertical view 650, and a top view 670. The third stage 600 performs multi-tier etching going through the WLs.

The 3-D view 610 shows the etching of the contact hole 615 and the WLs 422 and 424. The vertical view 550 shows the etching of the contact hole 615 as seen on the vertical surface. The numeral reference 615 refers to any of the contact holes being etched and not necessarily the same one. The top view 670 is the same as the top view 470 in FIG. 4 because the CMC etching does not create any new elements as seen from the top.

In the 3-D view 610, the contact hole 615 is shown etched through the tiers further down. The vertical view 650 shows the same in vertical view. The top view 670 shows the initial placement of the contact points 675. Two positions are shown in 685.

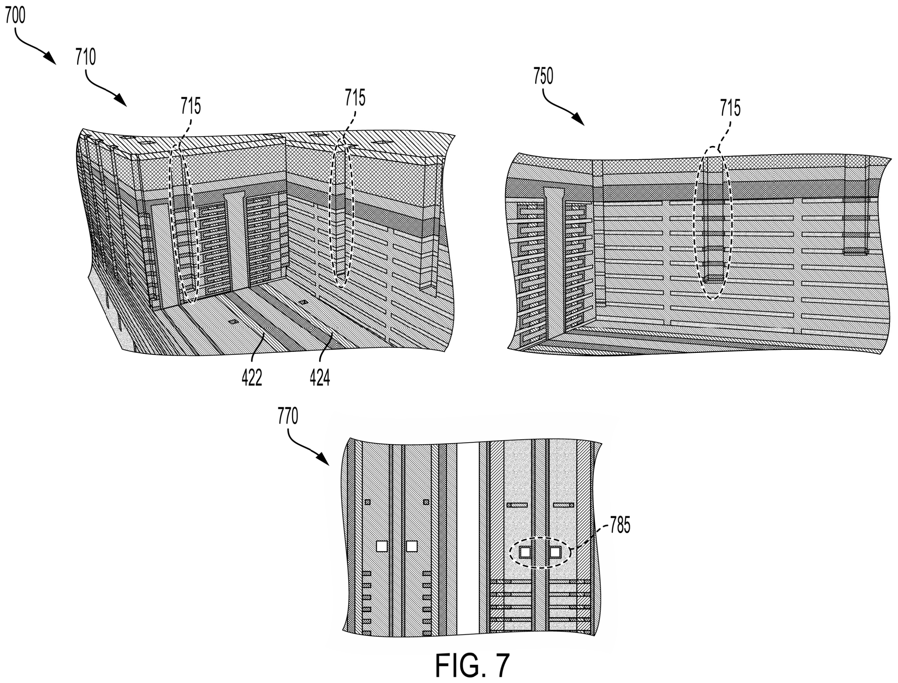

FIG. 7 is a diagram illustrating a fourth stage 700 of the manufacturing process of the pad structure according to an embodiment. The fourth stage 700 includes a 3-D view 710, a vertical view 750, and a top view 770. The fourth stage 700 performs forming lateral recess isolation and trimming. The forming of lateral recess isolation and trimming includes the steps of etching laterally, depositing dielectric, and removing excess dielectric.

The 3-D view 710 shows the contact hole 715 and the WLs 422 and 424. The vertical view 750 shows the contact hole 715 on the vertical surface. The top view 770 shows the positions of the two contact points 785.

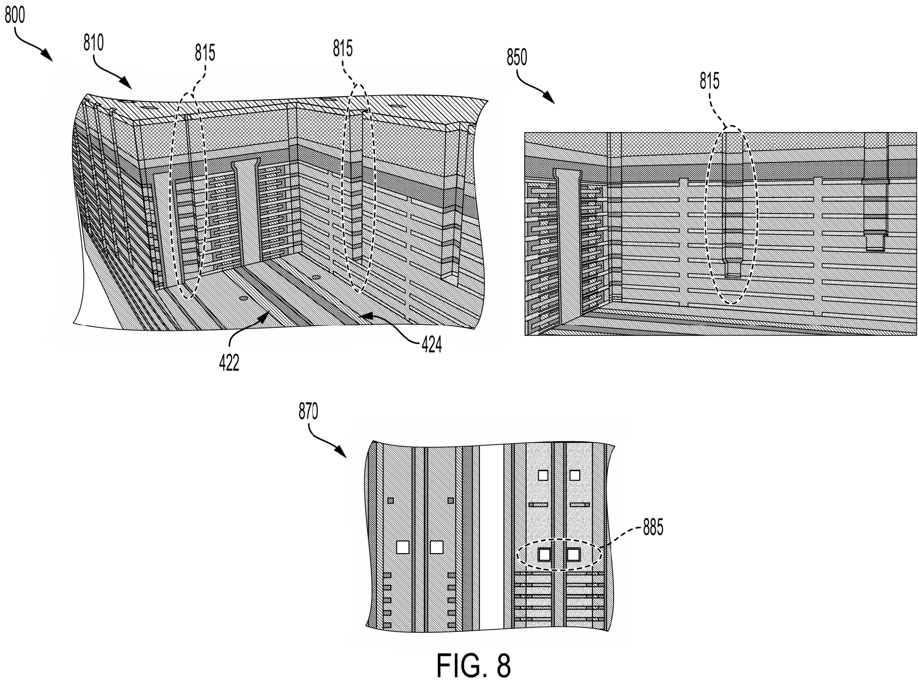

FIG. 8 is a diagram illustrating a fifth stage 800 of the manufacturing process of the pad structure according to an embodiment. The fifth stage 800 includes a 3-D view 810, a vertical view 850, and a top view 870. The fifth stage 800 performs etching to touch down to a target tier.

The 3-D view 810 shows the contact hole 815 stretching further down to touch the final or target tier and the WLs 422 and 424. The vertical view 850 shows the contact hole 815 on the vertical surface. The top view 870 shows the positions of the two contact points 885.

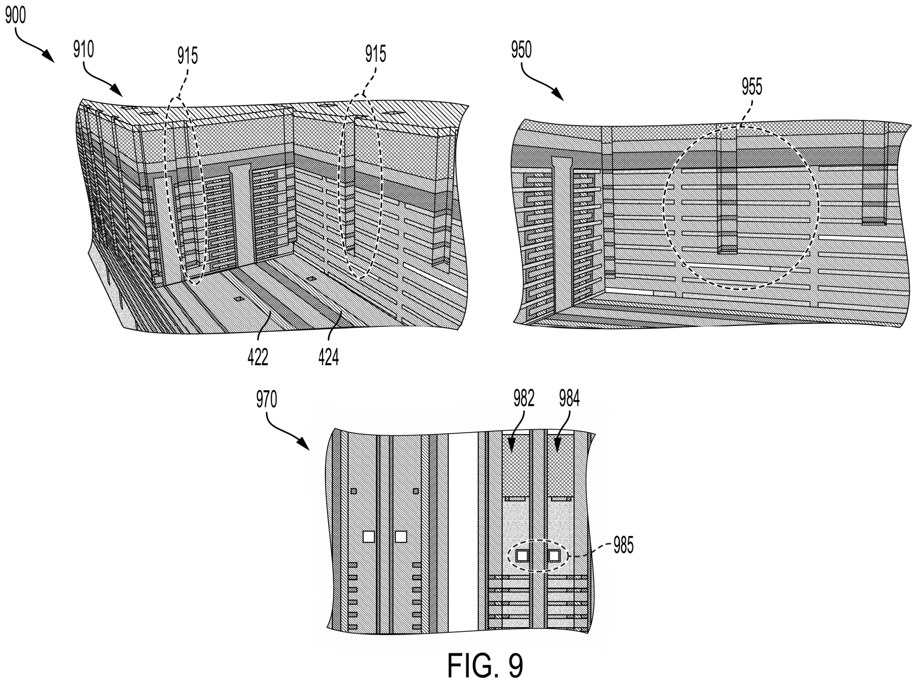

FIG. 9 is a diagram illustrating a sixth stage 900 of the manufacturing process of the pad structure according to an embodiment. The sixth stage 900 includes a 3-D view 910, a vertical view 950, and a top view 970. The sixth stage 900 performs a self-aligned plug formation and depositing oxide on the contact point based on the contact points.

The 3-D view 910 shows the contact hole 915 having the contact pad formation and the WLs 422 and 424. The vertical view 950 shows the contact hole 915 on the vertical surface. The top view 970 shows the positions of the two contact points 985 and the positions of a first contact pad 982 and a second contact pad 984.

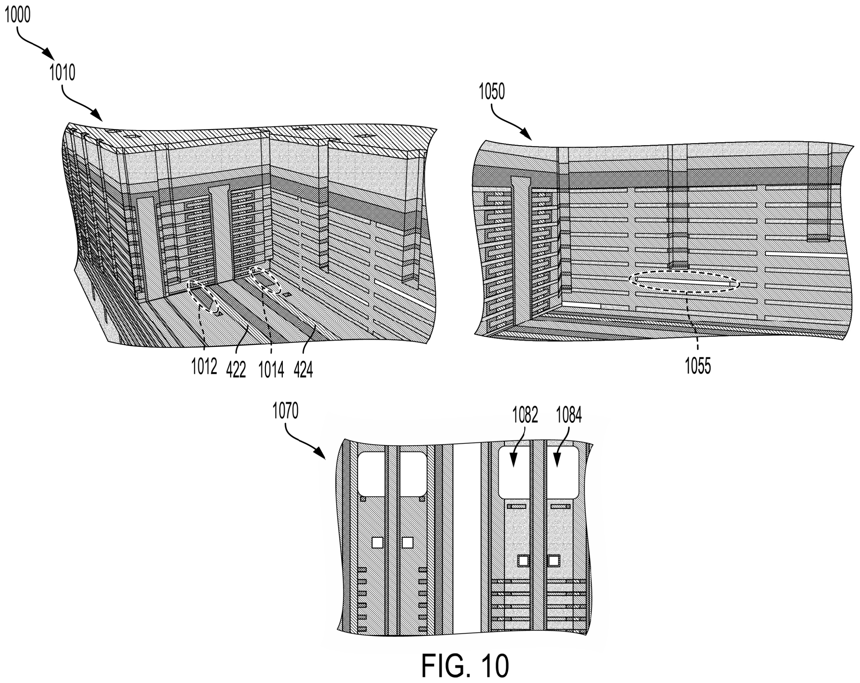

FIG. 10 is a diagram illustrating a seventh stage 1000 of the manufacturing process of the pad structure according to an embodiment. The seventh stage 1000 includes a 3-D view 1010, a vertical view 1050, and a top view 1070. The seventh stage 1000 performs clean-up or removal of gate oxide.

The 3-D view 1010 shows the gate oxide 1012 and 1014 and the WLs 422 and 424. The vertical view 1050 shows the area 1055 on the vertical surface. The top view 1070 shows the positions of a first contact pad 1082 and a second contact pad 1084.

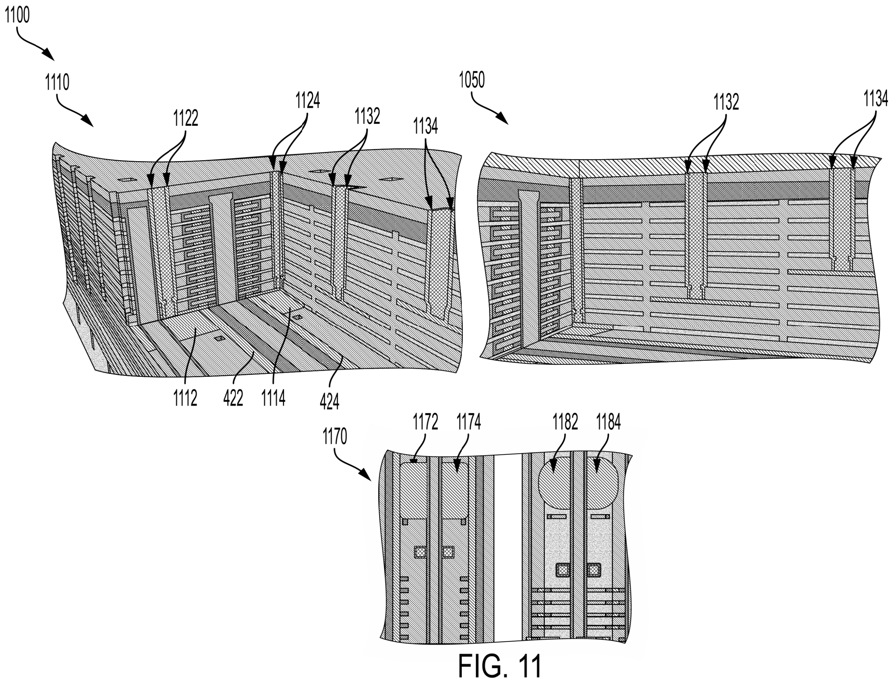

FIG. 11 is a diagram illustrating an eighth stage 1100 of the manufacturing process of the pad structure according to an embodiment. The eighth stage 1100 includes a 3-D view 1110, a vertical view 1150, and a top view 1170. The eighth stage 1100 performs depositing a conductive material into the contact hole. Examples of conductive materials include tungsten, titanium nickel, platinum, rhodium, aluminum copper, silver, gold or an alloy of one or more of the above metals, or titanium nitride (TiN), tantalum nitride (TaN), tungsten nitride (WN), etc.

The 3-D view 1110 shows contact holes 1122, 1124, 1132, and 1134 filled with metal and the WLs 422 and 424. The vertical view 1150 shows the contact holes 1132 and 1134 on the vertical surface. The top view 1170 shows the formation of a first contact pad 1172 and a second contact pad 1174 and a corresponding pair including a first contact pad 1182 and a second contact pad 1184.

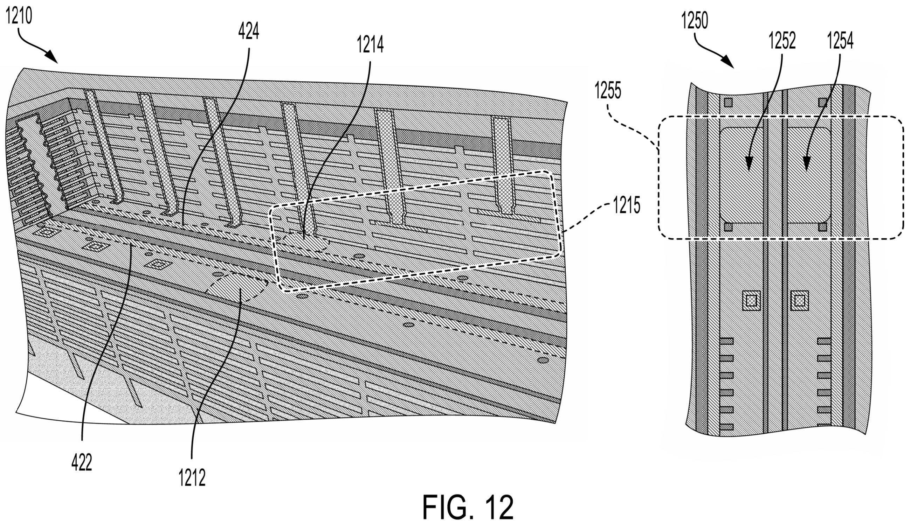

FIG. 12 is a diagram illustrating key features of the pad structure according to an embodiment. The key features of the pad structure are shown in a view 1210 and a view 1250. The view 1210 shows the 3-D cutout with the pad area 1215, the WLs 422 and 424, and a first pad 1212 and a second pad 1214. The view 1250 includes the pad structure 1255 which include a first pad 1252 and a second pad 1254. The key features include: (1) the WLs 422 and 424 are extended and do not occupy the entire width of the contact pad; (2) the pad area 125 shows the second pad 1214 positioned locally in a small area on the contact point; and (3) the first pad 1252 and 1254 are placed on the respective contact points and connected to the WL 422 and 424, respectively.

The basic configuration of the pad structure is shown in FIG. 3. This basic configuration may be further modified in at least two optional configurations.

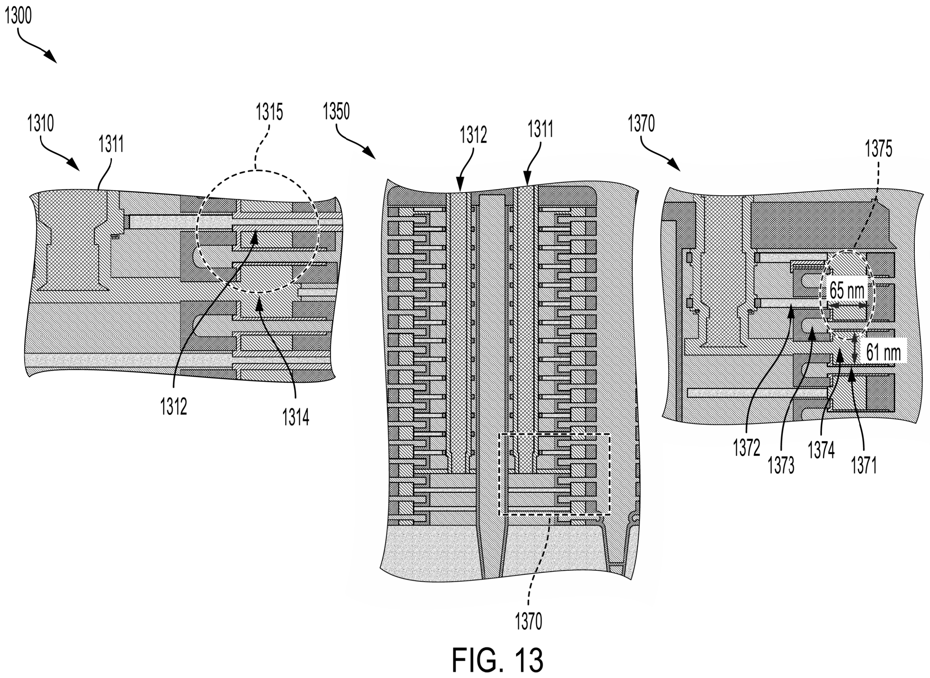

FIG. 13 is a diagram illustrating a first optional configuration 1300 of the pad structure according to an embodiment. The first optional configuration 1300 shows three views 1310, 1350, and 1370.

The view 1310 includes an end 1311, a base connector 1314, and an area 1315 including a connector 1312 connected to a conductive pad. The end 1311 is the end of a contact hole filled with metal. It is connected to the base connector 1314. The connector 1312 is a silicon connector and is above the conductive pad of the connector 1314. The view 1350 shows the contact holes 1311 and 1312 and the view 1370. The view 1370 shows a base connector 1374 and an aera 1375 including a connector 1372. The base connector 1374 is a modified version of the base connector 1314. The connectors are separated by dielectric separators 1371 and 1373. A silicon portion of the base connector 1314 is removed to leave only the metal base connector 1374. The connector 1372 is modified from the connector 1312 by replacing the silicon portion with metal. In other words, the silicon connector 1312 above the first conductive pad of the connector 1314 is replaced by metal. Some dimensional values are provided for illustrative purposes. The width of the metal 1375 is about 65 nm. The distance between the separators 1371 and 1373 is about 61 nm.

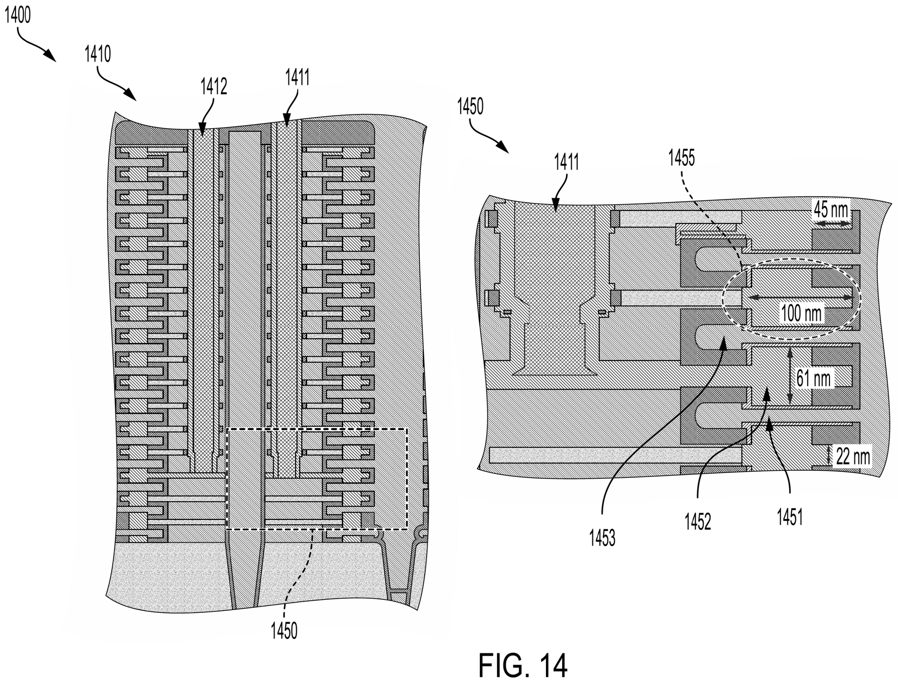

FIG. 14 is a diagram illustrating a second optional configuration 1400 of the pad structure according to an embodiment. The second optional configuration 1400 includes a view 1410 and a view 1450. The view 1410 shows two contact holes 1411 and 1412 and the area corresponding to the view 1450.

The view 1450 shows a base connector 1452 and a connector 1455. The base connector 1452 is connected to a pad. The connectors are separated by dielectric separators 1451 and 1453. The connector 1455 is initially made of silicon. A portion of the connector 1455 above the conductive pad of the base connector 1452 is replaced by metal in a T- shape configuration. Some dimensional values are provided for illustrative purposes. The portion of the connector 1455 replaced by metal is about 100 nm long. The portion extended from the metal WL is about 45 nm long. The distance between the separators 1451 and 1453 is about 61 nm. The thickness of the connectors is about 22 nm.

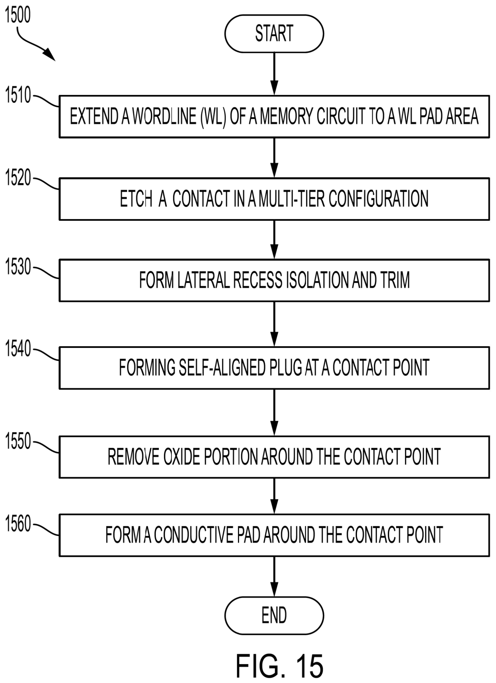

FIG. 15 is a flow chart illustrating a process 1500 of manufacturing a pad structure for a memory circuit according to an embodiment.

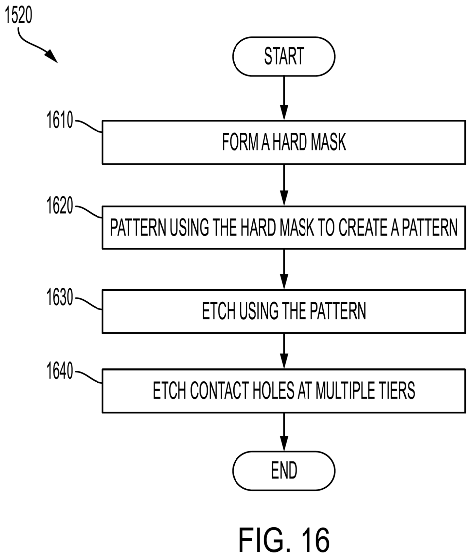

Upon START, the process 1500 extends a wordline (WL) of a memory circuit to a WL pad area (Block 1510). The extension extends the entire length as necessary for the WLs but with narrow width, sufficient to make connections with contact points. These WLs are shown as WLs 422 and 424 in FIGS. 4-11. Next, the process 1500 etches a contact in a multi-tier configuration (Block 1520). The etching will be described further in FIG. 16. Then, the process 1500 forms lateral recess isolation and trimming (Block 1530). This is to provide the contact holes, vias, or plugs to go through the tiers or levels of WLs. Next, the process 1500 forms a self-aligned plug at a contact point (Block 1540). The self-alignment is carried out thanks to the positions of the contact points and the alignment is in the direction that is substantially perpendicular to the direction of the WLs.

Then, the process 1500 removes oxide portion around the contact point (Block 1550). Next, the process 1500 forms a conductive pad around the contact point (Block 1560). This is to provide material for electrical conduction. The process 1500 is then terminated.

FIG. 16 is a flow chart illustrating the process 1520 shown in FIG. 15 of etching a contact in a multi-tier configuration as part of a process of manufacturing a pad structure for a memory circuit according to an embodiment.

Upon START, the process 1520 forms a hard mask (Block 1610). This may be done in a variety of techniques. In some embodiments, this may be done by depositing a thin film of silicon dioxide, silicon nitride, or come metal on a substrate. Next, the process 1520 patterns using the hard mask to create a pattern (Block 1620). In some embodiments, this may be done using photolithography. Then, the process 1520 etches using the pattern (Block 1630). The etching may be carried out by any suitable techniques such as wet etching or dry etching. Next, the process 1520 etches contact holes at multiple tiers (Block 1640) and is then terminated.

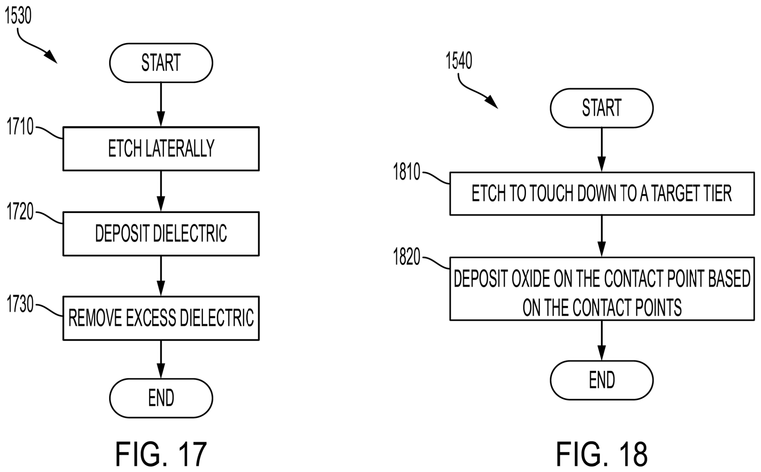

FIG. 17 is a flow chart illustrating the process 1530 shown in FIG. 15 of forming lateral recess isolation as part of a process of manufacturing a pad structure for a memory circuit according to an embodiment.

Upon START, the process 1530 etches laterally (Block 1710). The etching technique may be any suitable techniques including wet or dry etching. Next, the process 1530 deposits dielectric into the holes of the contact holes (Block 1720). Then, the process 1530 removes excess dielectric to trim the contact holes (Block 1730). The process 1530 is then terminated.

FIG. 18 is a flow chart illustrating the process 1540 shown in FIG. 15 of forming self-aligned plug as part of a process of manufacturing a pad structure for a memory circuit according to an embodiment.

Upon START, the process 1540 etches to touch down to a target tier (Block 1810). This may be done by etching deep into the tiers until the target tier is reached. Next, the process 1540 deposits oxide on the contact point based on the contact points (Block 1820). The process 1540 is then terminated.

Embodiments of the subject matter and the operations described in this specification may be implemented in digital electronic circuitry, or in computer software, firmware, or hardware, including the structures disclosed in this specification and their structural equivalents, or in combinations of one or more of them. Embodiments of the subject matter described in this specification may be implemented as one or more computer programs, i.e., one or more modules of computer-program instructions, encoded on computer-storage medium for execution by, or to control the operation of data-processing apparatus. Alternatively or additionally, the program instructions can be encoded on an artificially-generated propagated signal, e.g., a machine-generated electrical, optical, or electromagnetic signal, which is generated to encode information for transmission to suitable receiver apparatus for execution by a data processing apparatus. A computer-storage medium can be, or be included in, a computer-readable storage device, a computer-readable storage substrate, a random or serial-access memory array or device, or a combination thereof. Moreover, while a computer-storage medium is not a propagated signal, a computer-storage medium may be a source or destination of computer-program instructions encoded in an artificially-generated propagated signal. The computer-storage medium can also be, or be included in, one or more separate physical components or media (e.g., multiple CDs, disks, or other storage devices). Additionally, the operations described in this specification may be implemented as operations performed by a data-processing apparatus on data stored on one or more computer-readable storage devices or received from other sources.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable sub-combination. Moreover, although features may be described above as acting in certain combinations and even initially claimed as such, one or more features from a claimed combination may in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A device comprising:
a first pad on a first contact point and connected to a first wordline, WL, that is positioned lengthwise in a first direction and at a first distance from the first contact point; and
a second pad on a second contact point and connected to a second WL that is positioned lengthwise in the first direction and at a second distance from the second contact point,
wherein the first and second pads are aligned in a second direction based on the first and second contact points, and
wherein the first and second WLs correspond to row lines of a memory circuit.

2. The device of claim 1, wherein the first and second directions are substantially perpendicular.

3. The device of claim 1 or 2, wherein the first and second pads are separated by an insulating segment positioned lengthwise in the first direction, wherein the insulating segment exemplarily comprises one of a dielectric or an oxide.

4. The device of any one of claims 1 to 3, wherein the first and second pads are localized within first and second sections of the first and second WLs, respectively.

5. The device of any one of claims 1 to 4, wherein the memory circuit has a 3-D configuration.

6. The device of any one of claims 1 to 5, wherein at least one of the first pad or the second pad is connected to a vertical contact hole filled with a conductive material.

7. The device of any one of claims 1 to 6, wherein a portion of a silicon connector above one of the first conductive pad or the second conductive pad is replaced by metal, exemplarily by metal in a T- shape configuration.

8. The device of any one of claims 1 to 7, wherein at least one of the first pad or the second pad comprises a metal including one of titanium nitride, TiN, tungsten, W, or gold, Au.

9. A method comprising:
extending a wordline, WL, of a memory circuit to a WL pad area;
etching a contact in a multi-tier configuration;
forming lateral recess isolation and trimming;
forming self-aligned plug at a contact point;
removing oxide portion around the contact point; and
forming a conductive pad around the contact point.

10. The method of claim 9, wherein etching the contact in the multi-tier configuration comprises:
forming a hard mask;
patterning using the hard mask to create a pattern;
etching using the pattern; and
etching contact holes at multiple tiers.

11. The method of claim 9 or 10, wherein forming the lateral recess isolation and trimming comprises:
etching laterally;
depositing dielectric; and
removing excess dielectric, and/or
wherein forming the self-aligned plug comprises:
etching to touch down to a target tier; and
depositing oxide on the contact point based on the contact points.

12. The method of any one of claims 9 to 11, wherein forming the conductive pad around the contact point comprises:
filling the contact hole with a conductive material, the conductive material exemplarily comprising a metal including one of titanium nitride, TiN, tungsten, W, or gold, Au.

13. The method of any one of claims 9 to 12, wherein the memory circuit has a 3-D configuration.

14. The method of any one of claims 9 to 13, further comprising:
replacing a portion of a silicon connector above the conductive pad by metal, exemplarily by metal in a T-shape configuration.

15. A memory circuit comprising a wordline, WL, pad area having a pad structure which is defined by the features of any one of claims 1 to 8.
